# EUROPEAN PATENT APPLICATION

(11) **EP 1 139 524 A2**
(43) Date of publication of application: **04.10.2001**
(21) Application number: 01400807.2
(22) Date of filing: 29.03.2001
(51) Int. Cl.: H01S 5/14

(54) **External resonator type laser light source**

(30) Priority: 30.03.2000 JP 2000095642
(71) Applicant: ANDO ELECTRIC CO., LTD., Tokyo (JP)
(72) Inventor: Yagi, Toshiyuki, Ohta-ku, Tokyo (JP)
(74) Representative: Ilgart, Jean-Christophe

(57) **Abstract**

The external resonator type laser light source of the present invention is equipped with a rotation mechanism for varying a selected wavelength according to the angle of a mirror (3), and a semiconductor laser (1) provided with a reflection preventive film (1A) on one end surface, and which converts outgoing light from an end surface on the reflection preventive film side of the semiconductor laser to parallel light, returns this parallel light to a diffraction grating (2) with the mirror after selecting the wavelength of this parallel light with the diffraction grating, and excites the laser by again selecting a wavelength with the diffraction grating and returning the light to the semiconductor laser; wherein, a photodiode (14) is provided that couples either outgoing light (A) from the end surface of the semiconductor laser not provided with the reflection preventive film or zero-order light (B) of the diffraction grating to an optical fiber (9), and receives into which any of the light is not used for coupling to the optical fiber.

## Description

### BACKGROUND OF THE INVENTION

### Field of the Invention

The present invention relates to an external resonator type laser light source used in the field of optical communication.

### Description of the Related Art

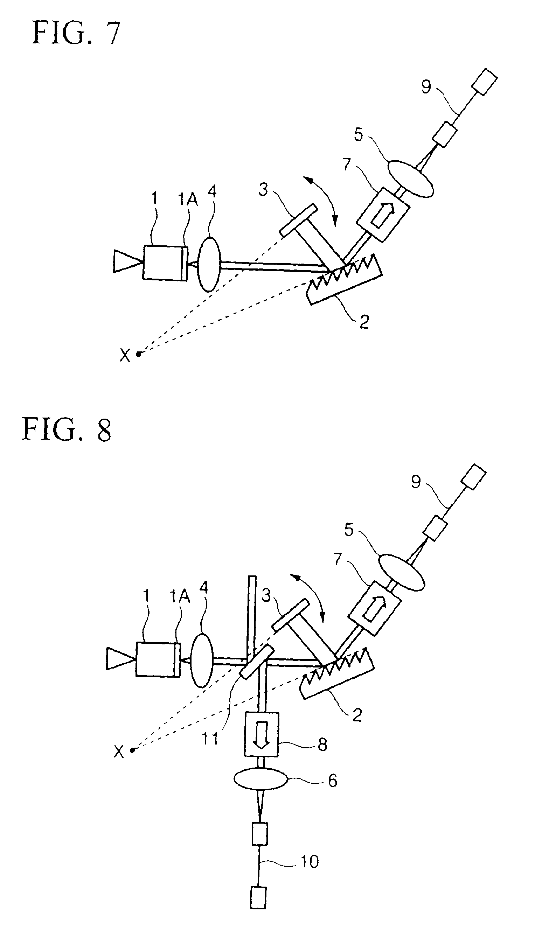

An explanation of an external resonator type laser light source of the prior art is provided using Figs. 7 through 12.

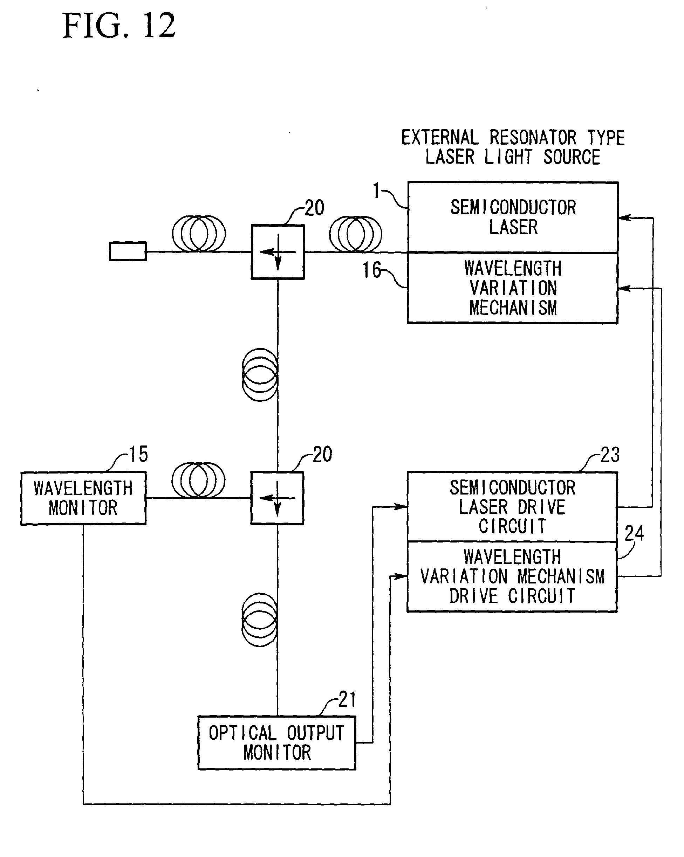

Figs. 7 through 11 are schematic drawings showing one example of an external resonator type laser light source of the prior art, while Fig. 12 is a block diagram showing one example of an external resonator type laser light source of the prior art.

In Figs. 7 through 11, reference symbol 1 indicates a semiconductor laser; 2 a diffraction grating; 3 a mirror, 4, 5 and 6 lenses; 7 and 8 optical isolators; 9 and 10 optical fibers; 11 a beam splitter; 12 a band pass filter; and 13 a partial reflecting mirror.

The external resonator type laser light source of the prior art shown in Fig. 7 is equipped with a rotation mechanism for varying a selected wavelength according to the angle of the mirror 3, is provided with a reflection preventive film 1A on one end surface of the semiconductor laser 1, converts outgoing light from this end surface of the reflection preventive film side into parallel light by the lens 4, returns this parallel light to the diffraction grating 2 after selecting a wavelength with the diffraction grating 2, and excites the laser by returning this light to the above semiconductor laser 1 after again selecting a wavelength with the diffraction grating 2.

Zero-order light of the diffraction grating 2 passes through the optical isolator 7 and is coupled to the optical fiber 9 after being collected by the lens 5.

The external resonator type laser light source shown in Fig. 8 is the external resonator type laser light source shown in Fig. 7 equipped with the beam splitter 11 between the semiconductor laser 1 and the diffraction grating 2, wherein return light extracted by the above beam splitter 11 passes through the optical isolator 8, is collected by the lens 6, and is then coupled to the optical fiber 10.

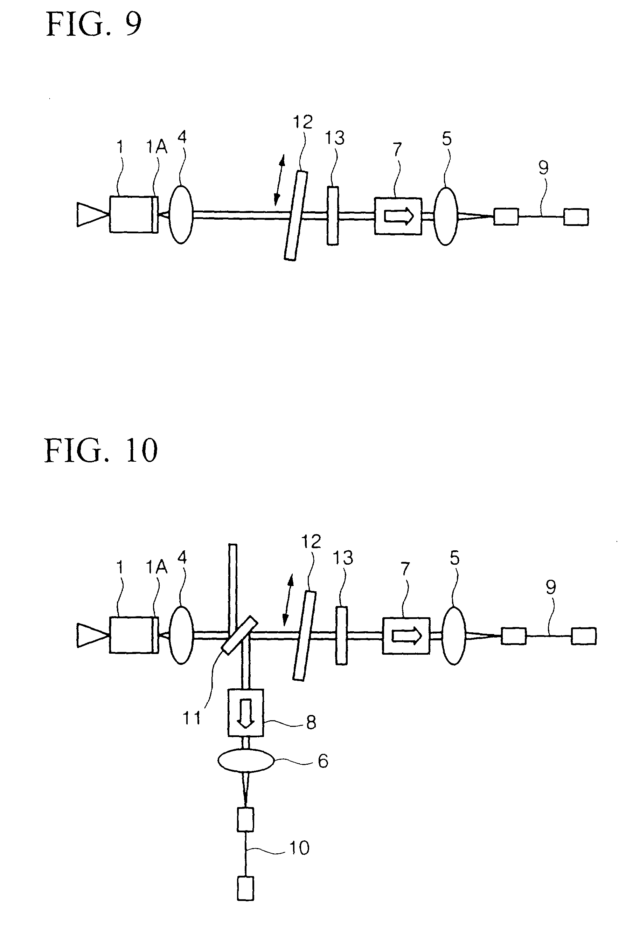

The external resonator type laser light source shown in Fig. 9 is the external resonator type laser light source shown in Fig. 7 equipped with a slide mechanism for varying a selected wavelength with the band pass filter 12 by using the band pass filter 12 that continuously changes the film thickness in place of the diffraction grating 2, uses the partial reflecting mirror 13 for the mirror, and arranges the partial reflecting mirror behind the band pass filter 12.

The external resonator type laser light source shown in Fig. 10 is the external resonator type laser light source of the prior art shown in Fig. 9 equipped with the beam splitter 11 between the semiconductor laser 1 and the band pass filter 12, wherein return light extracted by the above beam splitter 11 passes through the optical isolator 8, is gathered by the lens 6, and is coupled to the optical fiber 10.

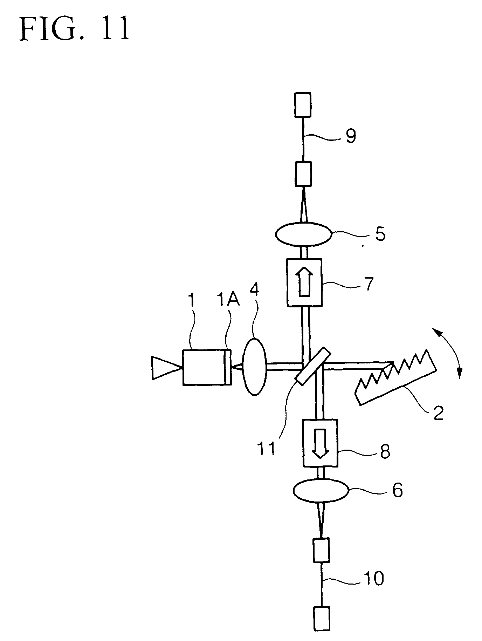

The external resonator type laser light source shown in Fig. 11 is the external resonator type laser light source shown in Fig. 8 equipped with a rotation mechanism for varying a selected wavelength according to the angle of the diffraction grating 2 by selecting a wavelength with the above diffraction grating 2 without using the mirror 3, and exciting a laser by returning that light to the above semiconductor laser 1. wavelength variation mechanism drive circuit.

In addition, in the block diagram of an external resonator type laser light source of the prior art shown in Fig. 12, together with controlling the drive current of a semiconductor laser so as to maintain a constant optical output by splitting the outgoing light from the output optical fiber by an optical coupler and the like, directing that light into an optical output monitor and a wavelength monitor, and returning the signal from the optical output monitor to a semiconductor laser drive circuit (APC driving), a wavelength variation mechanism is controlled so as to excite the laser at a set wavelength by returning the signal of the wavelength monitor to a wavelength variation mechanism drive circuit.

In the external resonator type laser light source, the excitation state of the external resonator must be at the optimum position in order to achieve excitation at a single, stable wavelength at all times. Moreover, the positional accuracy of the optical components that compose the external resonator is extremely high.

Consequently, the optical components that compose the external resonator may shift out of position and the excitation state of the external resonator may deteriorate due to temperature, humidity and other environmental changes, etc., thereby making it necessary to monitor the excitation state of the external resonator and maintain the excitation state of the external resonator at the optimum position.

The excitation state of the external resonator is at the optimum position when the optical power within the external resonator reaches a maximum. The excitation state of the external resonator can be monitored by measuring changes in optical power inside the external resonator with a photodiode. Although optical power is measured with an optical output monitor in external resonator type laser light sources of the prior art, since light of the output optical fiber enters after being split with an optical coupler and so forth, fluctuations resulting from environmental changes in the coupling state to the optical fiber, as well as fluctuations resulting from environmental changes and so forth in the propagation state in the optical fiber, are included in the signal. Consequently, although an optical output monitor is effective for controlling the drive current of a semiconductor laser so as to maintain a constant optical output by returning the signal to a semiconductor laser drive circuit (APC driving), an optical output monitor is unable to accurately measure changes in optical power within the external resonator, thereby preventing monitoring of the excitation state of the external resonator.

### SUMMARY OF THE INVENTION

In order to solve the above problems, the present invention discloses an external resonator type laser light source which is equipped with a rotation mechanism for varying a selected wavelength according to the angle of a mirror and a semiconductor laser provided with a reflection preventive film on one end surface, and which converts outgoing light from an end surface on the reflection preventive film side of the semiconductor laser into parallel light, returns this parallel light to a diffraction grating with a mirror after selecting the wavelength of said parallel light with a diffraction grating, and excites the laser by again selecting a wavelength with the diffraction grating and returning the light to said semiconductor laser; wherein, a photodiode is provided that couples either outgoing light from the end surface of the semiconductor laser not provided with the reflection preventive film or zero-order light of the diffraction grating to a first optical fiber, and receives into which any of the light is not used for coupling to the first optical fiber.

In addition, the present invention also discloses the external resonator type laser light source as described above which is equipped with a beam splitter between the semiconductor laser and the diffraction grating, and which couples return light extracted by said beam splitter to a second optical fiber; wherein, a photodiode is provided that couples either outgoing light from the end surface of the semiconductor laser not provided with the reflection preventive film, zero-order light of the diffraction grating, or reflected light of the beam splitter to the first optical fiber, and receives into which any of the light which is not used for coupling to the first optical fiber.

Furthermore, this external resonator type laser light source may be equipped with a rotation mechanism for varying a selected wavelength according to the angle of the diffraction grating, which selects a wavelength with the diffraction grating without using the mirror and returns it to the semiconductor laser; wherein, a photodiode is provided that couples either outgoing light from the end surface of the semiconductor laser not provided with the reflection preventive film, or reflected light of the beam splitter to the first optical fiber, and receives into which any of the light is not used for coupling to the first optical fiber.

In addition, the present invention also discloses the external resonator type laser light source as described above which is equipped with a slide mechanism for varying a selected wavelength of a band pass filter, which uses a band pass filter that continuously changes the film thickness in place of the diffraction grating, and which uses a partial reflecting mirror for the mirror, and arranges the partial reflecting mirror behind the band pass filter; wherein, the photodiode is provided that couples either outgoing light from the end surface of the semiconductor laser not provided with the reflection preventive film, or transmitted light of the mirror to the first optical fiber, and receives into which any of the light is not used for coupling to the first optical fiber.

Furthermore, this external resonator type laser light source may be equipped with a beam splitter between the semiconductor laser and the band pass filter, which couples return light extracted by the beam splitter to the second optical fiber; wherein, the photodiode is provided that couples either outgoing light from the end surface of the semiconductor laser not provided with the reflection preventive film, reflected light of said beam splitter, or transmitted light of the mirror to the first optical fiber, and receives into which any of the light which is not used for coupling to the first optical fiber.

In addition, in anyone of the above described external resonator type of laser light source, an external resonator correction mechanism by returning the signal of the photodiode to an external resonator correction mechanism drive circuit may be provided.

### BRIEF DESCRIPTION OF THE DRAWINGS

Fig. 1 is a schematic drawing showing an example of an external resonator type laser light source according to the present invention.
Fig. 2 is a schematic drawing showing another example of an external resonator type laser light source according to the present invention.
Fig. 3 is a schematic drawing showing another example of an external resonator type laser light source according to the present invention.
Fig. 4 is a schematic drawing showing another example of an external resonator type laser light source according to the present invention.
Fig. 5 is a schematic drawing showing another example of an external resonator type laser light source according to the present invention.
Fig. 6 is a block diagram showing an example of an external resonator type laser light source according to the present invention.
Fig. 7 is a schematic drawing showing an example of an external resonator type laser light source according to the prior art.
Fig. 8 is a schematic drawing showing another example of an external resonator type laser light source according to the prior art.
Fig. 9 is a schematic drawing showing another example of an external resonator type laser light source according to the prior art.
Fig. 10 is a schematic drawing showing another example of an external resonator type laser light source according to the prior art.
Fig. 11 is a schematic drawing showing another example of an external resonator type laser light source according to the prior art.
Fig. 12 is a block diagram showing an example of an external resonator type laser light source according to the prior art.

### DETAILED DESCRIPTION OF THE PREFERRED EMBODIMENTS

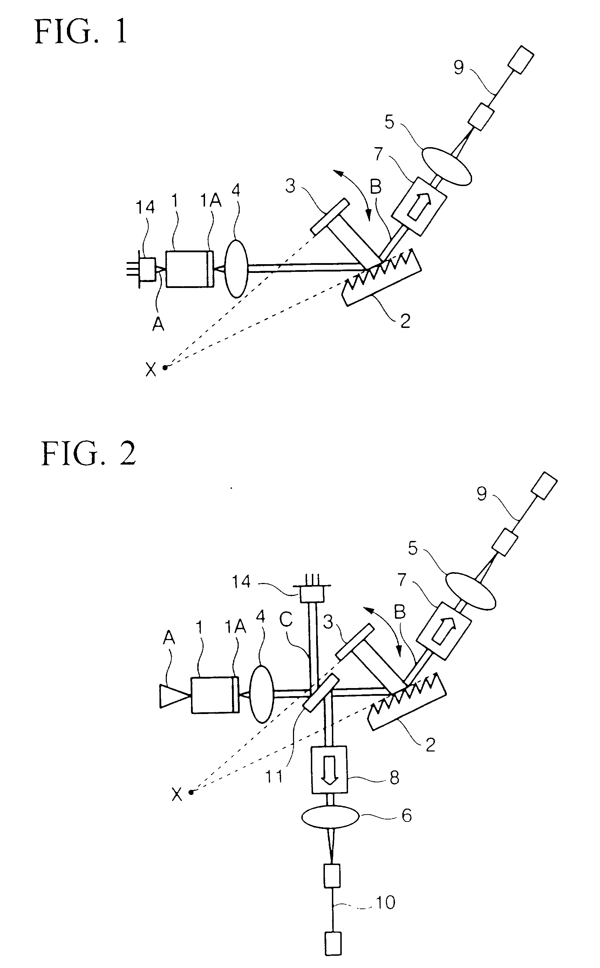

The following provides an explanation of an external resonator type laser light source according to the present invention with reference to the drawings of Figs. 1 through 6.

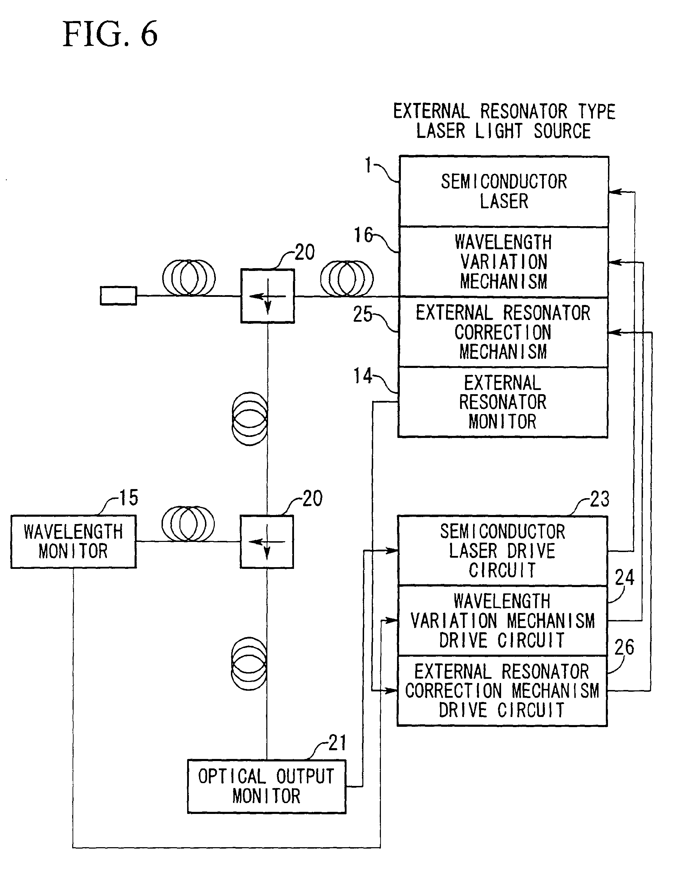

Figs. 1 through 5 are schematic drawings showing examples of external resonator type laser light sources according to the present invention, while Fig. 6 is a block diagram showing an example of an external resonator type laser light source according to the present invention.

In Figs. 1 through 5, reference symbol 1 indicates a semiconductor laser; 2 a diffraction grating; 3 a mirror, 4, 5 and 6 lenses; 7 and 8 optical isolators; 9 and 10 optical fibers; 11 a beam splitter; 12 a band pass filter; 13 a partial reflecting mirror; and 14 a photodiode.

In the external resonator type laser light source of the embodiment shown in Fig. 1, a reflection preventive film 1A is provided on one end surface of the semiconductor laser 1, and an outgoing light from this end surface of the reflection preventive film side is converted into parallel light by the lens 4. This parallel light is led to the diffraction grating 2, and the parallel light that has entered this diffraction grating 2 is divided into a radial form for each wavelength. The light of a wavelength that enters perpendicular to the reflecting surface of the mirror 3 again enters the diffraction grating 2, and follows the original light path after being divided again, returning to the semiconductor laser 1, resulting in laser excitation. This type of configuration is referred to as the Littman type. Since light travels back and forth within an external resonator due to the diffraction grating 2 resulting in the selection of two wavelengths, this configuration has superior wavelength selectivity, and is known as one of the most common methods.

A rotation mechanism is provided for varying the selected wavelength according to the angle of the mirror 3 in this embodiment, so that the wavelength that enters perpendicular to the reflecting surface of the mirror 3 can be changed by changing the angle of the mirror 3. Location X of the mirror's center of rotation is preferably arranged at the location described in Japanese Unexamined Patent Application, First Publication No. 2000-164979, and enables continuous, uninterrupted variation by mode hopping during wavelength variation.

In this embodiment, zero-order light B of the diffraction grating 2 passes through the optical isolator 7, is collected by the lens 5 and is coupled to the optical fiber (first optical fiber) 9, while outgoing light A from the end surface of the semiconductor laser 1 not provided with a reflection preventive film is received by the photodiode 14.

Furthermore, light is coupled to the optical fiber 9 and light received by the photodiode 14 may be either outgoing light A from the end surface of the semiconductor laser 1 not provided with a reflection preventive film, or zero-order light B of the diffraction grating 2.

The embodiment of the external resonator type laser light source shown in Fig. 2 is equipped with the beam splitter 11 between the semiconductor laser 1 and the diffraction grating 2 that extracts a portion of the return light returned from the diffraction grating 2 to the semiconductor laser 1 in the external resonator type laser light source of Fig. 1. In this embodiment, return light extracted by the beam splitter 11 passes through the optical isolator 8, is collected by the lens 6, and is coupled to the optical fiber (second optical fiber) 10. Since this return light is light immediately following two rounds of wavelength selection that has traveled back and forth due to the diffraction grating 2, extremely uniform, single-wavelength light can be obtained that is free of natural emitted light components emitted from the semiconductor laser 1 (see Japanese Unexamined Patent Application, First Publication No. 11-126943).

In this embodiment, zero-order light B of the diffraction grating 2 passes through the optical isolator 7, is collected by the lens 5 and is coupled to the optical fiber 9, while reflected light C of the beam splitter 11 is received by the photodiode 14.

Furthermore, light that is coupled to the optical fiber 9 and light received by the photodiode 14 may be any of outgoing light A from the end surface of the semiconductor laser 1 not provided with a reflection preventive film, zero-order light B of the diffraction grating 2, or reflected light C of the beam splitter 11.

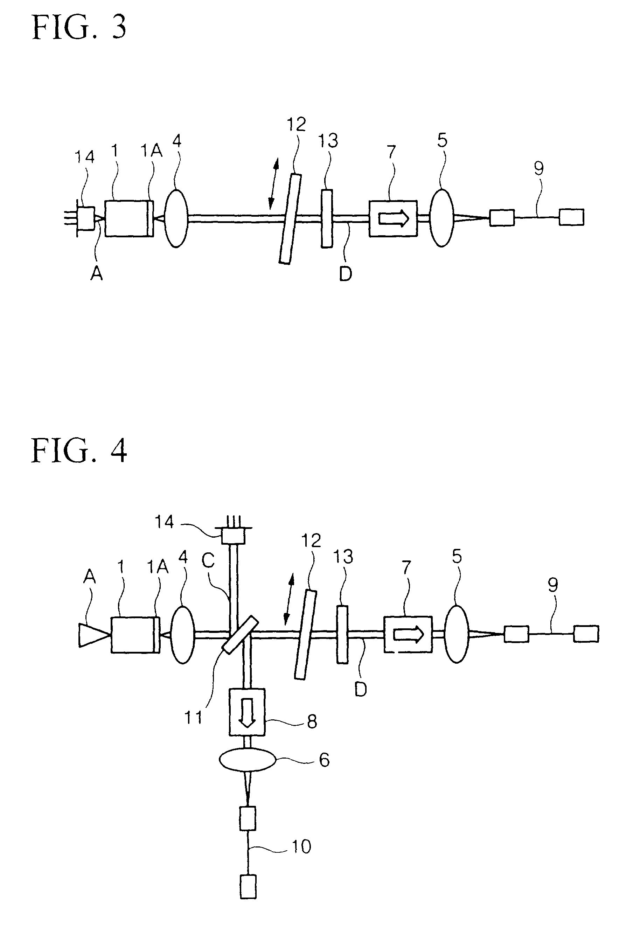

The embodiment of the external resonator type laser light source shown in Fig. 3 uses the band pass filter 12 that continuously changes the film thickness in place of the diffraction grating 2, uses the partial reflecting mirror 13 for the mirror and arranges the partial reflecting mirror 13 behind the band pass filter 12 in the external resonator type laser light source shown in Fig. 1. Only parallel light of a selected wavelength that has entered this band pass filter 12 passes through the band pass filter 12, after which it is reflected by the partial reflecting mirror 13, again passes through the band pass filter 12, and returns to the semiconductor laser 1 resulting in laser excitation.

This external resonator type laser light source is equipped with a slide mechanism for varying the selected wavelength according to the position of the band pass filter 12, and therefore, the wavelength of light that passes through the band pass filter 12 can be changed by sliding the band pass filter 12 in a direction in which the film thickness changes.

In this embodiment, transmitted light D of the partial reflecting mirror 13 passes through the optical isolator 7, is collected by the lens 5 and is coupled to the optical fiber 9, while outgoing light A from the end surface of the semiconductor laser 1 not provided with a reflection preventive film is received by the photodiode 14.

Furthermore, light coupled to the optical fiber 9 and light received by the photodiode 14 may be either outgoing light A from the end surface of the semiconductor laser 1 not provided with a reflection preventive film, or transmitted light D of the partial reflecting mirror 13.

The embodiment of the external resonator type laser light source shown in Fig. 4 is equipped with the beam splitter 11 between the semiconductor laser 1 and the band pass filter 12 that extracts a portion of the return light returned from the band pass filter 12 to the semiconductor laser 1 in the external resonator type laser light source of Fig. 3. In this embodiment, return light extracted by the beam splitter 11 passes through the optical isolator 8, is collected by the lens 6, and is coupled to the optical fiber 10.
Since this return light is light immediately following two rounds of wavelength selection that has traveled back and forth due to the band pass filter 12, extremely uniform, single-wavelength light can be obtained that is free of natural emitted light components emitted from the semiconductor laser 1 (see Japanese Unexamined Patent Application, First Publication No. 11-126943).

In this embodiment, transmitted light D of the partial reflecting mirror 13 passes through the optical isolator 7, is collected by the lens 5 and is coupled to the optical fiber 9, while reflected light C of the beam splitter 11 is received by the photodiode 14.

Furthermore, light coupled to the optical fiber 9 and light received by the photodiode 14 may be any of outgoing light A from the end surface of the semiconductor laser 1 not provided with a reflection preventive film, reflected light C of the beam splitter 11 or transmitted light D of the partial reflecting mirror 13.

In addition, in the case of using the mirror 3 in place of the partial reflecting mirror 13, light coupled to the optical fiber 9 and light received by the photodiode 14 may be either outgoing light A from the end surface of the semiconductor laser 1 not provided with a reflection preventive film, or reflected light C of the beam splitter 11.

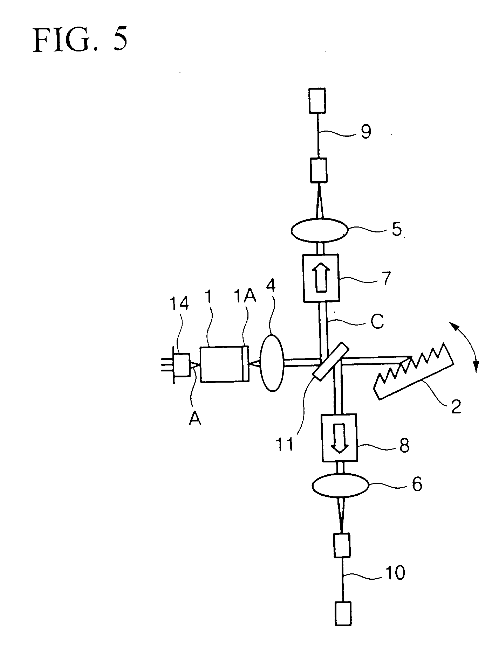

The embodiment shown in Fig. 5 is the external resonator type laser light source that returns light to a semiconductor laser after selecting a wavelength with the diffraction grating 2 without using the mirror 3 in the external resonator type laser light source shown in Fig. 2. Parallel light that has entered this diffraction grating 2 is divided into a radial form for each wavelength, and only light of a wavelength that coincides with the original light path is returned to the semiconductor laser 1 resulting in laser excitation. This type of configuration is referred to as the Lithrow type, and is known as one of the most basic methods.

A rotation mechanism is provided for varying the selected wavelength according to the angle of the diffraction grating 2 in this embodiment, so that the wavelength of light divided with the diffraction grating 2 that coincides with the original light path can be changed by changing the angle of the diffraction grating 2.

In this embodiment, reflected light C of the beam splitter 11 passes through the optical isolator 7, is collected by the lens 5 and is coupled to the optical fiber 9, while outgoing light A from the end surface of the semiconductor laser 1 not provided with a reflection preventive film is received by the photodiode 14.

Furthermore, light coupled to the optical fiber 9 and light received by the photodiode 14 may be either outgoing light A from the end surface of the semiconductor laser 1 not provided with a reflection preventive film, or reflected light C of the beam splitter 11.

According to the external resonator type laser light source shown in any of the Figs. 1 through 5, changes in optical power inside the external resonator can be measured accurately, and the excitation state of the external resonator can be monitored by the photodiode 14.

Fig. 6 is a block diagram showing an example of an external resonator type laser light source according to the present invention. In this block diagram, in the embodiments of the external resonator type laser light source shown in any of the Figs. 1 through 5, an external resonator correction mechanism is controlled so that the signal of the photodiode 14 (external resonator monitor) is returned to an external resonator correction mechanism drive circuit so as to maximize the optical power inside the external resonator, thereby maintaining the excitation state of the external resonator at the optimum position.

The external resonator correction mechanism refers to a mechanism that is installed on the diffraction grating 2, mirror 3 or partial reflecting mirror 13 that compose the external resonator, and is composed of a piezo device and so forth that performs swinging position correction of optical components or correction of external resonator length.

In this external resonator correction mechanism, since changes in optical power inside the external resonator can be measured accurately, and the excitation state of the external resonator can be monitored by the photodiode 14, the external resonator correction mechanism can be controlled so as to maximize optical power inside the external resonator by returning a signal from the photodiode 14 to the external resonator correction mechanism drive circuit, thereby being able to correct the excitation state of the external resonator to the optimum position.

The present invention is not necessarily limited to the above-mentioned embodiments, and easily allows various other variations.

## Claims

1. An external resonator type laser light source equipped with a rotation mechanism for varying a selected wavelength according to the angle of a mirror and a semiconductor laser provided with a reflection preventive film on one end surface, which converts outgoing light from an end surface on the reflection preventive film side of said semiconductor laser into parallel light, returns this parallel light to a diffraction grating with a mirror after selecting the wavelength of said parallel light with said diffraction grating, and excites the laser by again selecting a wavelength with said diffraction grating and returning the light to said semiconductor laser; wherein, a photodiode is provided that couples either outgoing light from the end surface of said semiconductor laser not provided with said reflection preventive film or zero-order light of said diffraction grating to a first optical fiber, and receives into which any of the light is not used for coupling to the first optical fiber.

2. An external resonator type laser light source according to claim 1, which is equipped with a beam splitter between said semiconductor laser and said diffraction grating, which couples return light extracted by said beam splitter to a second optical fiber; wherein, said photodiode is provided that couples either outgoing light from the end surface of said semiconductor laser not provided with said reflection preventive film, zero-order light of said diffraction grating or reflected light of said beam splitter to the first optical fiber, and receives into which any of the light which is not used for coupling to the first optical fiber.

3. An external resonator type laser light source according to claim 1, which is equipped with a slide mechanism for varying a selected wavelength of a band pass filter, and which uses the band pass filter that continuously changes the film thickness in place of said diffraction grating, uses a partial reflecting mirror for the mirror, and arranges said partial reflecting mirror behind the band pass filter; wherein, said photodiode is provided that couples either outgoing light from the end surface of said semiconductor laser not provided with said reflection preventive film or transmitted light of said mirror to the first optical fiber, and receives into which any of the light is not used for coupling to the first optical fiber.

4. An external resonator type laser light source according to claim 3, which is equipped with a beam splitter between said semiconductor laser and said band pass filter, and which couples return light extracted by said beam splitter to a second optical fiber; wherein, said photodiode is provided that couples outgoing light from the end surface of said semiconductor laser not provided with said reflection preventive film, reflected light of said beam splitter or transmitted light of said mirror to the first optical fiber, and receives into which any of the light which is not used for coupling to the first optical fiber.

5. An external resonator type laser light source according to claim 2, which is equipped with a rotation mechanism for varying a selected wavelength according to the angle of said diffraction grating, and which selects a wavelength with said diffraction grating without using said mirror and returns said light to said semiconductor laser; wherein, said photodiode is provided that couples either outgoing light from the end surface of said semiconductor laser not provided with said reflection preventive film or reflected light of said beam splitter to the first optical fiber, and receives into which any of the light is not used for coupling to the first optical fiber.

6. An external resonator type laser light source according to any of claims 1 through 5 that controls an external resonator correction mechanism by returning the signal of said photodiode to an external resonator correction mechanism drive circuit.
